# EUROPEAN PATENT SPECIFICATION

(11) **EP 0 437 834 B1**
(45) Date of publication and mention of the grant of the patent: **13.03.1996**
(21) Application number: 90125499.5
(22) Date of filing: 27.12.1990
(51) Int. Cl.: H01L 21/266, H01L 21/82, H01L 21/331, H01L 21/033, H01L 21/76

(54) **Method for manufacturing a semiconductor integrated circuit**
Verfahren zur Herstellung einer integrierten Halbleiterschaltung
Procédé pour la fabrication d'un circuit intégré à semiconducteur

(30) Priority: 28.12.1989 JP 340810/89; 28.12.1989 JP 340813/89; 28.12.1989 JP 340814/89; 28.12.1989 JP 340816/89
(43) Date of publication of application: 24.07.1991
(73) Proprietor: SANYO ELECTRIC CO., LTD., Moriguchi-shi, Osaka (JP)
(72) Inventor: Takeda, Kazuo, Outa-shi, Gunma (JP); Sekikawa, Nobuyuki, Ouizumi-machi, Oura-gun, Gunma (JP); Tabata, Teruo, Oura-gun, Gunma (JP); Sano, Yoshiaki, Ouizumi-machi, Oura-gun, Gunma (JP)
(74) Representative: Wächtershäuser, Günter, Prof. Dr.

(56) References cited:
- EP-A- 0 005 164
- EP-A- 0 007 923
- FR-A- 2 260 186
- US-A- 3 915 766
- US-A- 3 933 528
- US-A- 4 780 425
- Latest LSI Process Technology, April 25, 1984, published by the Industrial Board of Inquiry, Japan (relevant pages filed by the applicant with letter dated 2.1.95)

## Description

### BACKGROUND OF THE INVENTION

### Field of the Invention:

The present invention relates in general to a method of manufacturing a semiconductor integrated circuit with a high degree of integration. The present invention relates, in particular, to a method for manufacturing a semiconductor integrated circuit characterized by using a mask where doping windows for an isolating region and for element regions have simultaneously been formed, selectively diffusing dopants into these regions, and thereby forming these regions with a small size which meets the design specifications.

### Description of the Background Art:

A method of manufacturing a bipolar transistor and the configuration thereof are discussed in detail in the *Latest LSI Process Technology, April 25, 1984,* published by Industrial Board of Inquiry, Japan.

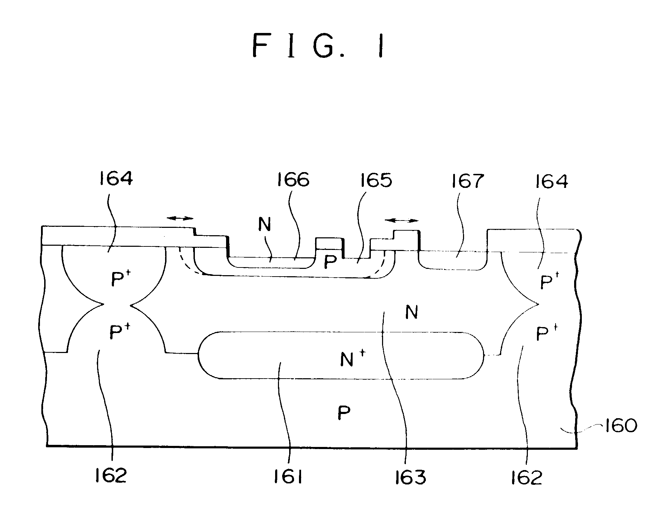

Fig. 1 shows the configuration of the bipolar transistor disclosed in above literature. This bipolar transistor comprises: a collector region 163 which is an island formed in an N-type epitaxial layer 163 from a lower isolating region 162 and an upper isolating region 164; a P-type base region 165 formed within the island; and an N⁺-type emitter region 166 formed within the base region 165.

This type of bipolar transistor is manufactured by a process comprising the steps of:
(i) forming a SiO₂ film on a P-type semiconductor substrate 160, forming a doping window for the buried layer 161 in the SiO₂ film, and selectively doping the P-type semiconductor substrate 160 with antimony through the doping window;
(ii) forming a SiO₂ film again on the P-type semiconductor substrate 160, forming a doping window for the lower isolating region 162 in this SiO₂ film, and selectively doping the semiconductor substrate 160 with boron through the doping window;
(iii) growing the epitaxial layer 163 on the surface of the semiconductor substrate 160, followed by forming an SiO₂ film on the surface of the epitaxial layer 163;
(iv) forming a doping window for the upper isolating region 164 in the SiO₂ film on the surface of the epitaxial layer 163 and selectively doping the epitaxial layer 163 with boron through the doping window;
(v) heat-treating the semiconductor substrate 160, and diffusing the various regions which were doped in the foregoing steps simultaneously, linking the lower isolating region 162 and the upper isolating region 164;
(vi) forming a doping window for the base region 165 in the SiO₂ film on the surface of the epitaxial layer 163, selectively doping the epitaxial layer 163 with boron through the doping window to form the base region 165; and
(vii) forming doping windows for the emitter region 166 and for a collector contact region 167 in the SiO₂ film on the surface of the epitaxial layer 163, and doping the epitaxial layer 163 with phosphorous (P) through the doping windows to form the emitter region 166 and the collector contact region 167.

However, because the upper isolating region 164, the base region 165, and the collector contact region 167, which are formed in steps (iv), (vi), and (vii), are selectively doped through different SiO₂ films, there is concern that the positions which these regions occupy will deviate from the design values, as shown by the dotted lines in Fig. 1, because of the mask alignment required to form the doping windows in each SiO₂ film or for the subsequent etching. For this reason, the spacing of these regions must be designed to provide a preset allowance so that contact between these regions resulting from the diffusion treatment is avoided. This is a hindrance to high integration.

In step (vii) of this method for manufacturing a bipolar transistor, a portion of the SiO₂ film for the base region 165 has become thinner than a portion of the SiO₂ film for the collector contact region 167 through the previous steps of forming the doping window for the base region 166. This causes various problems when forming the doping windows for the emitter region 166 and collector contact region 167. In particular, side etching of the portion of the SiO₂ film for the emitter region 166 will proceed prior to completely etching the portion of the SiO₂ film for the collector contact region 167 and as a result the portion of the SiO₂ film for the emitter region 166 will be expanded beyond the design value. Also, even the emitter region 166 itself will be etched depending on the etchant used. The similar problems exist when forming contact holes.

In step (v) where the heat-treatment is performed at a high temperature for a long period of time, the lateral diffusion of the upper isolating region 164 will become large. The area occupied by the upper isolating region 164 in the epitaxial layer 163 consequently becomes large. This gives the problem that an improvement in integration cannot be expected.

### SUMMARY OF THE INVENTION

Accordingly, it is a first object of the present invention to provide a method for manufacturing a semiconductor integrated circuit wherein base regions of transistors are formed with a size and position which meet the design specifications, and, in particular, the space between the base region of a vertical transistor and a isolating region is minimized, thereby providing the semiconductor integrated circuit with a high degree of integration.

It is a second object of the present invention to provide a method for manufacturing a semiconductor integrated circuit wherein a collector region and emitter region of a lateral transistor are formed with a size and position which meet the design specifications.

It is a third object of the present invention to provide a method for manufacturing a semiconductor integrated circuit wherein a collector leading region and emitter region of a vertical transistor are formed with a size and position which meet the design specifications.

It is a fourth object of the present invention to provide a method for manufacturing a semiconductor integrated circuit wherein doping windows and/or contact holes can be formed with the design size in a SiO₂ film, thereby providing the semiconductor integrated circuit with a high degree of integration.

The above objects can be achieved by methods as defined in the independent claims.

Other objects, features and advantages of the invention will hereinafter become more readily apparent from the following description.

### BRIEF DESCRIPTION OF THE DRAWINGS

Fig. 1 is a sectional drawing of a bipolar transistor manufactured by a conventional method, and
Fig. 2 to Fig. 15 are sectional drawings illustrative of each step in the manufacture of a semiconductor integrated circuit substrate manufactured by the method of manufacturing a semiconductor integrated circuit of the present invention.

### DETAILED DESCRIPTION OF THE INVENTION AND PREFERRED EMBODIMENTS

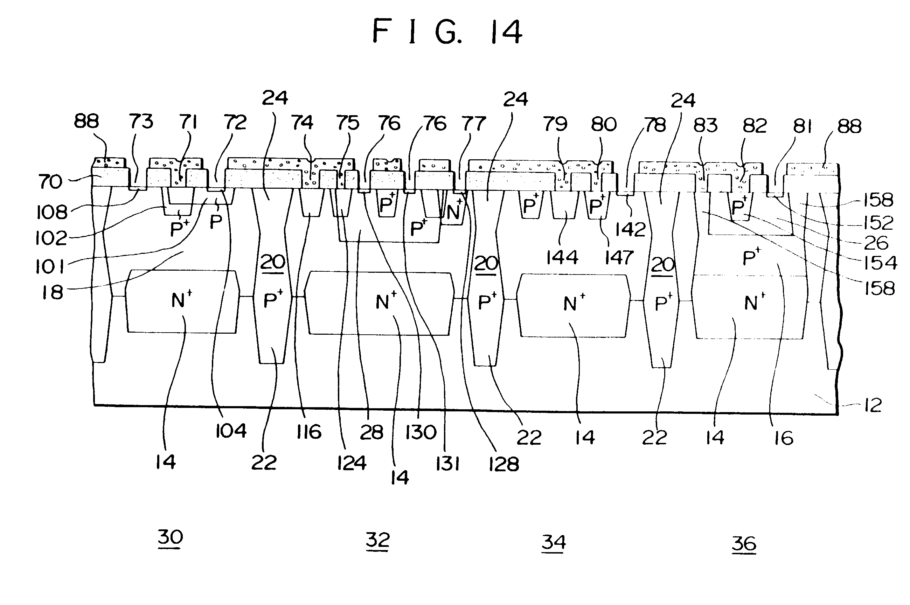

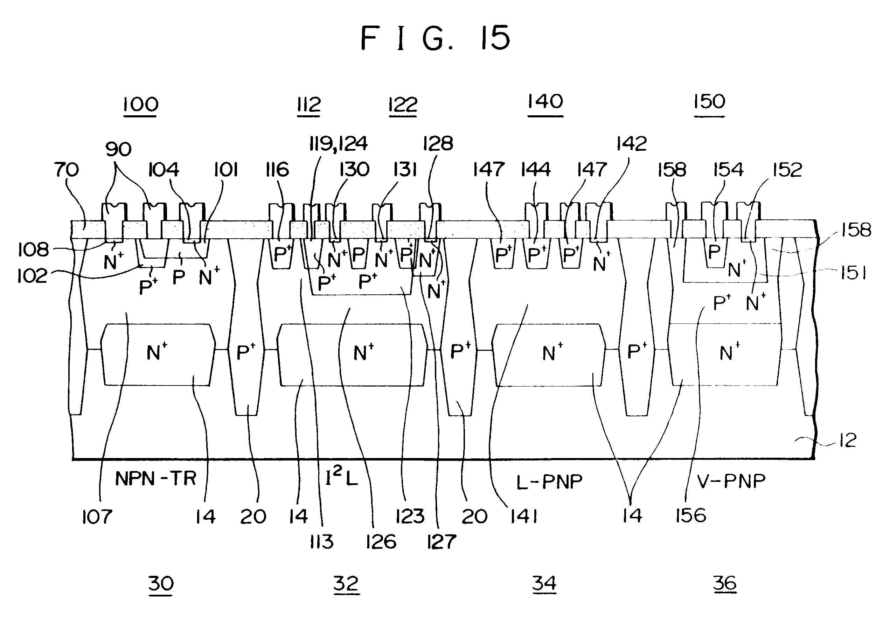

The configuration of the cross section of a semiconductor integrated circuit will be first explained with reference to Fig. 14 and Fig. 15 in order to easily understand the special masking steps of the present invention.

Referring to Fig. 14, the semiconductor integrated circuit of the present invention includes a P-type semiconductor substrate 12; an N-type epitaxial layer 18 grown-formed on the semiconductor substrate 12; a plurality of N⁺-type buried layers 14 formed by diffusion in the boundary region of the semiconductor substrate 12 and the N-type epitaxial layer 18; a P⁺-type buried layer 16; an N-type well 26; a P-type well 28; an isolating region 20, which reach the surface of the epitaxial layer 18 from the top of the semiconductor substrate 12 as well as the configuration of each type of integrated circuit element (later discussed) within the epitaxial layer 18. The semiconductor integrated circuit of the present invention also includes an insulating layer 70 which is a specific feature of the present invention and a plurality of electrodes 90 (see Fig. 15) formed through a contact hole formed in the insulating layer 70.

A plurality of isolating regions 20 is obtained by diffusing upward a P-type lower isolating region 22 to a depth of a little more than half the thickness of the epitaxial layer 18 wherein the P-type lower isolating region 22 has been formed on the surface of the semiconductor substrate 12 prior to growing the epitaxial layer 18, and by diffusing downward a P-type upper isolating region 24 to reach the lower isolating region 22 from the surface of the epitaxial layer 18. As illustrated in the drawing, the isolating regions 20 are formed to enclose the buried layer 14, and a plurality of electrically isolated islands 30, 32, 34, 36 is formed by the isolating regions 20.

With reference to Fig. 15, a vertical NPN transistor 100, an integrated injection logic (hereinafter simply referred to as "IL") constituted of a lateral PNP transistor 112 and a vertical NPN transistor 122, a lateral PNP transistor 140, and a vertical PNP transistor 150 are formed within the first to fourth islands 30, 32, 34, and 36 respectively.

The vertical NPN transistor 100 of the first island 30 includes a P-type base region 101, an N⁺-type emitter region 104, and a collector region 107 corresponding to the epitaxial layer 18 as shown in Fig. 14.

The lateral PNP transistor 112 of the second island 32 includes a base region 113 corresponding to the epitaxial layer 18 as shown in Fig. 14, a P⁺-type emitter region 116, and a P⁺-type collector region 119. The vertical NPN transistor 122 includes a base region 123 corresponding to the P⁺-type well as shown in Fig. 14, an emitter region 126 corresponding to the epitaxial layer 18 as shown in Fig. 14, and N⁺-type collector regions 130, 131. Stated additionally, the collector region 119 of the lateral PNP transistor 112 also serves as a base contact region 124 of the vertical NPN transistor 122, and the emitter region 116 serves as an injector region for the IL. An optional number of the collector regions 130, 131 of the vertical NPN transistor 122 may be formed depending on the intended use.

The lateral PNP transistor 140 of the third island 34 includes a base region 141 corresponding to the epitaxial layer 18 as shown in Fig. 14, an emitter region 144, and a collector region 147 formed around the emitter region 144.

The vertical PNP transistor 150 of the fourth island 36 includes a base region 151 corresponding to the N⁺-type well 26 as shown in Fig. 14, a collector region 157 corresponding to the P⁺-type buried layer 16 as shown in Fig. 14, a P⁺-type collector leading region 158 for bringing out the collector region 157 on the surface of an element, and a P⁺-type emitter region 154.

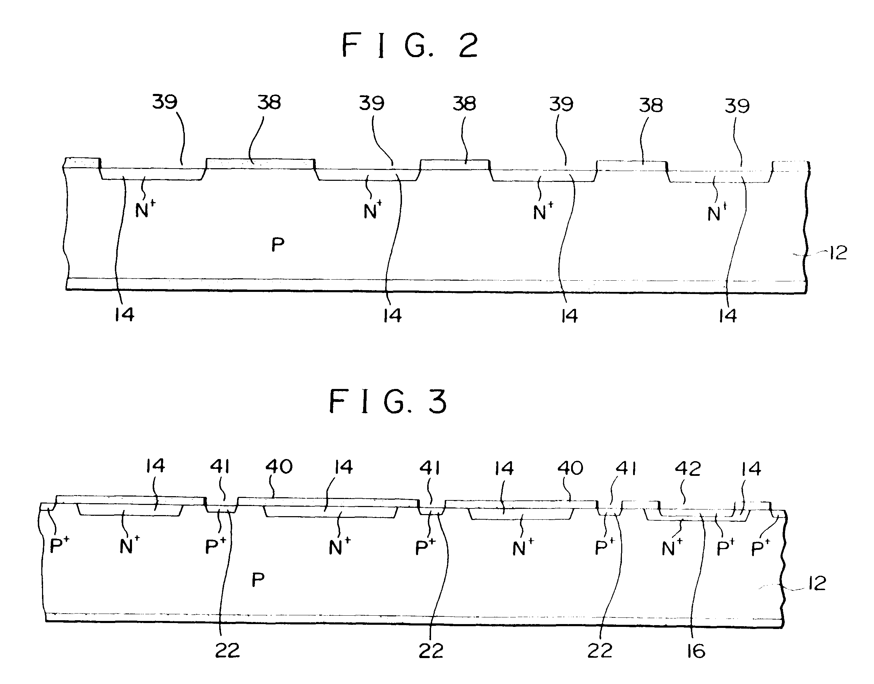

The masking steps of the present invention will now be explained in sequence, with reference to Fig. 2 to Fig. 15.

Now referring to Fig. 2, mainly, as a semiconductor substrate 12 which functions to provide necessary strength in the manufacturing process, a P-type silicon semiconductor with impurity concentration of about 10¹⁵ atom/cm³, and with a thickness of about 200 µm is used. An SiO₂ film 38 is formed on the surface of the semiconductor substrate 12 by a commonly known thermal oxidation process, and a specified area of this SiO₂ film 38 is opened by means of a commonly known photolithography to form an opening 39. Then, the semiconductor substrate 12 is doped through the opening 39 with antimony or arsenic, which are N-type dopants, to form the N⁺-type buried layer 14. In the following explanation, it is proper that the layer which is subsequently subjected to a diffusion process is expressed as a buried layer. However, because this is very complicated, for the sake of simplicity the same representation and reference numbers are hereinafter used for the layer immediately after doping, and for the layer which is subsequently subjected to diffusion.

Next, after the SiO₂ film 38 and impurities on the semiconductor substrate 12 are removed, an SiO₂ film 40 is newly formed on the semiconductor substrate 12. Specified areas of SiO₂ film 40 are opened by means of photolithography to form openings 41, 42. From these openings 41, 42, boron, which is a P⁺-type dopant, is introduced to dope the semiconductor substrate 12 to form the lower isolating region 22 and the P⁺-type buried layer 16 which will constitute the collector region of the vertical PNP transistor (see Fig. 3). Stated additionally, if a suitable mask is selected, the lower isolating region 22 and the P⁺-type buried layer 16 can also be formed by the ion implantation method.

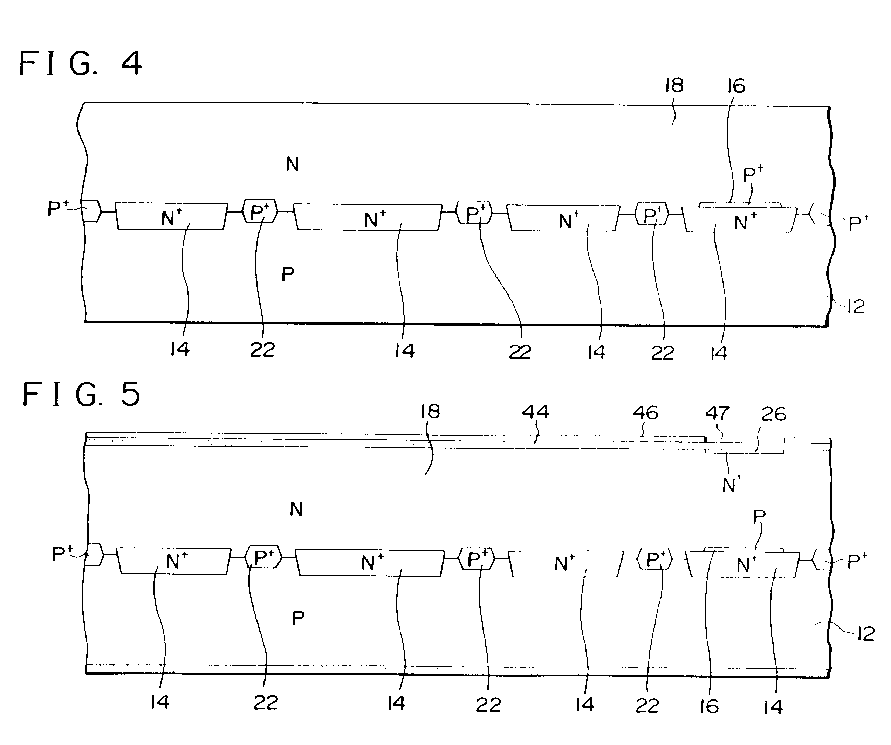

Now referring to Fig. 4, after the entire SiO₂ film 40 has been removed from the semiconductor substrate 12, an N-type epitaxial layer 18 with a specific resistance of 0.1 to 5 Ω.cm is grown to a thickness of about 2-7 µm on the semiconductor substrate 12 by a commonly known vapor phase deposition method. Hereinafter, for the sake of simplicity, the semiconductor substrate 12 combined with a region or layer formed by the subsequent step, for example, the epitaxial layer 18, is referred to as the semiconductor substrate 12, as the case may be.

During the growth of the epitaxial layer 18, the semiconductor substrate 12 is exposed to high temperatures, and the dopant which has previously been introduced to dope the semiconductor substrate 12 is diffused to a certain extent at that time.

Next, the semiconductor substrate 12 is subjected to thermal oxidation to form a SiO₂ film 44 with a thickness of about 50 nanometres on the epitaxial layer 18. A negative photoresist film 46 is then deposited on the SiO₂ film 44, and phosphorus ions are implanted through a doping window 47 formed in the photoresist film 46 to form the N⁺-type well 26. (See Fig. 5).

It is to be understood that the N⁺-type well 26 need not be necessarily formed because the epitaxial layer 18 per se may serve as an circuit element without any obstacle to the fundamental functions of the circuit. When the N⁺-type well 26 is not formed, the semiconductor substrate 12 is subjected directly to the step of depositing a photoresist 48 as described below, after the SiO₂ film 44 has been formed.

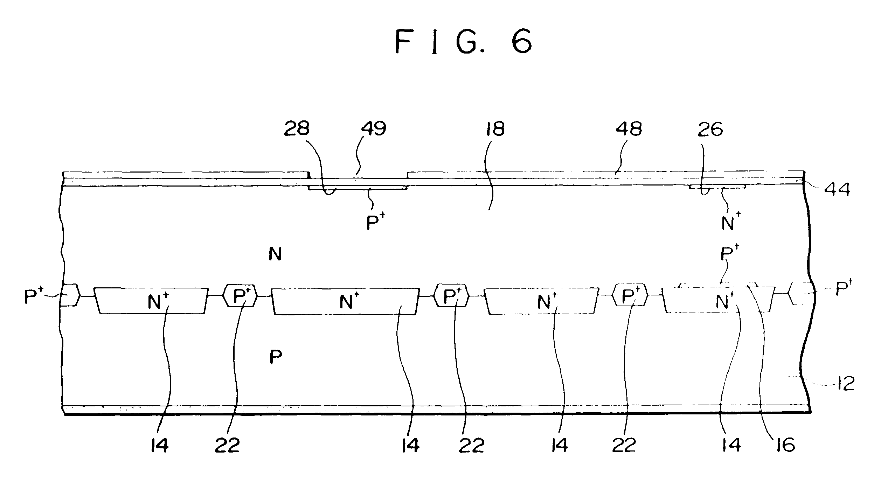

The resist film 46 is then removed, and a negative photoresist 48 is deposited on the semiconductor substrate 12. Boron ions are implanted through a doping window 49 formed in the resist film 48 to form the P⁺-type well 28. (See Fig. 6).

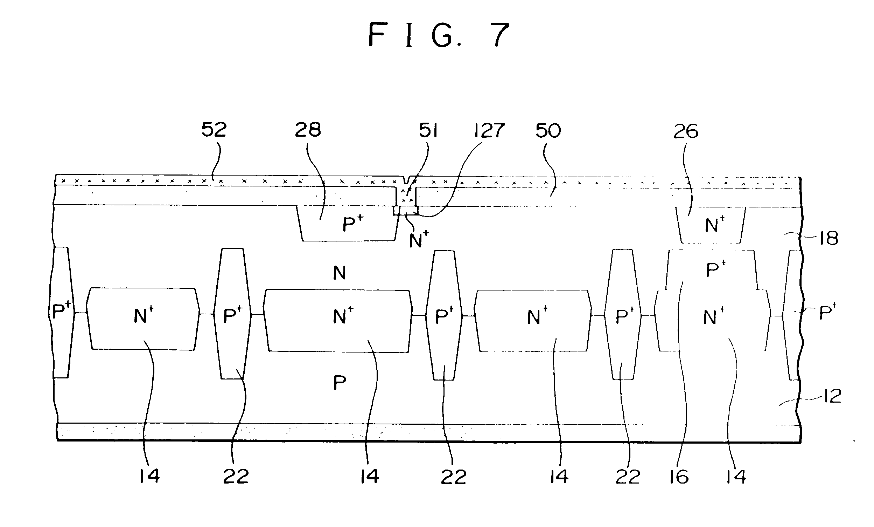

The semiconductor substrate 12 shown in Fig. 6 will be heat-treated at least two times as illustrated below. With reference to Fig. 7, first, the semiconductor substrate 12 is subjected to thermal oxidation for several hours at a temperature of about 1,000°C to form an SiO₂ film 50 on the surface of the epitaxial layer 18, and further heat-treated to diffuse the impurities introduced in the foregoing step. In this step the lower isolating region 22 is diffused upward to a depth of a little more than half the thickness of the epitaxial layer 18, i.e., it is substantially diffused upward near to the surface of the epitaxial layer 18. As will be later explained, the present invention is characterized by this step in which the lower isolating region 22 is diffused in the upward direction to a depth of a little more than half the thickness of the epitaxial layer 18.

Next, after a doping window 51 for an emitter leading region 127 is formed in the SiO₂ film 50, PoCl₃ indicated by the number 52, which is a diffusion source, is deposited on the entire surface of the substrate followed by a specified heat treatment. By this heat treatment, phosphorus (P) is diffused into the epitaxial layer 18 to form the emitter leading region 127. In addition, the substrate is subjected to a specified heat treatment after removing PoCl₃ 52.

By these heat treatments, the lower isolating region 22 is also diffused to the same extent in the lateral direction (on the drawing). If the width of the doping window for the lower isolating region 22 is, for example, 4 µm, the lower isolating region 22 reaches a maximum width of about 14 µm in subsequent steps. It is therefore effective for improving the circuit integration that the maximum thickness of the lower isolating region 22 is restrained by forming the epitaxial layer 18 as a thin layer. Also, by this step the SiO₂ film 50 on the surface of the epitaxial layer 18 is further grown to a thickness of several hundred nanometres, and is used as a mask for subsequent selective diffusion. This mask may also be a silicon nitride film, or the SiO₂ film which may newly be formed by the CVD process.

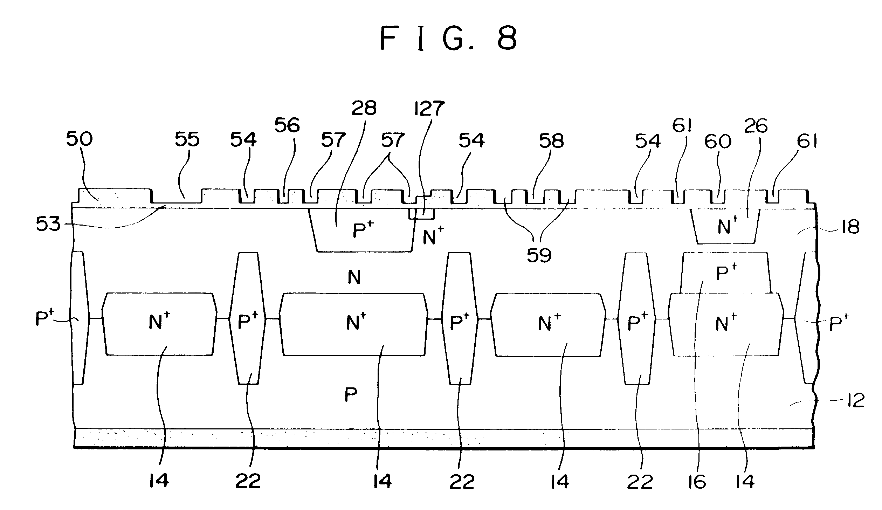

With reference to Fig. 8, a plurality of doping windows 54-61 is then simultaneously formed in the SiO₂ film 50 by means of photolithography using a positive-type resist film and dry etching. Following this, the exposed epitaxial layer 18 is oxidized and dummy oxidation film 53 is formed to reduce damage to the epitaxial layer 18 from the subsequent ion implantation steps and to implant the impurity ions uniformly.

The plurality of doping windows 54-61 is each respective window for the upper isolating region 24, the base region 101 of vertical NPN transistor 100, the emitter region 116 of lateral PNP transistor 112, the base contact region 124 of vertical NPN transistor 122, the emitter region 144 and collector region 147 of lateral PNP transistor 140, and the emitter region 154 and collector leading region 158 of vertical PNP transistor 150 as illustrated in Fig. 15. The step of simultaneously forming the doping windows 54-61 in the SiO₂ film 50 is a special feature of the present invention. As a SiO₂ film used in manufacturing stages and compared to other SiO₂ films of the present invention, in particular, to those used in the conventional manufacturing method, the SiO₂ film 50 is commonly used in subsequent steps for a longer time.

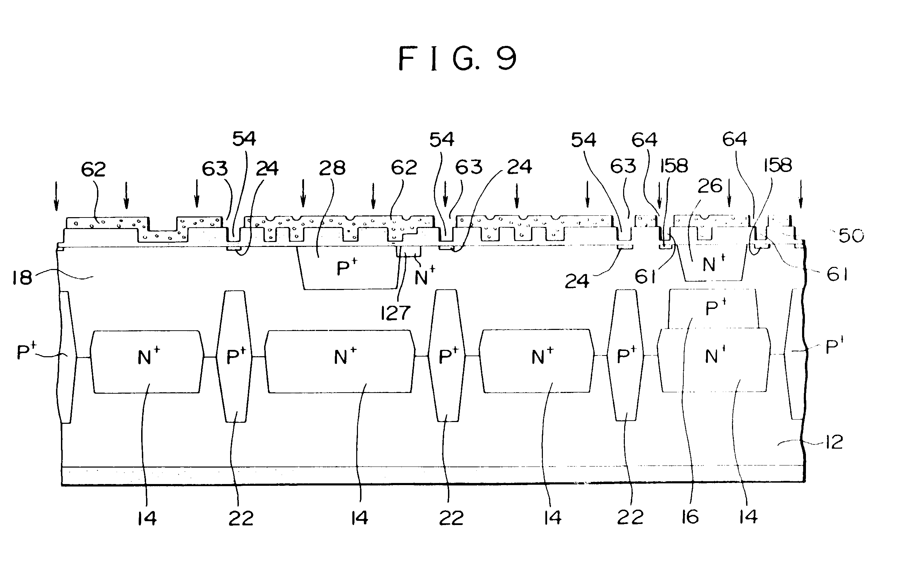

Next, a resist film 62 capable of blocking ion implantation is formed on the SiO₂ film 50, openings 63, 64 are made in the upper sections of the upper isolating region 24 and collector leading region 158, and boron ions are implanted through the doping windows 63, 64 to form the P-type upper isolating region 24 and the collector leading region 158. The present invention in which ion implantation is carried out through the SiO₂ film 50 and the resist film 62 has the advantage that slippage of the mask patterns for the SiO₂ film 50 and the resist film 62 can be tolerated. Specifically, the ions implanted from the doping windows 63, 64 of the resist film 62 are finally implanted in the epitaxial layer 18 according to the mask pattern of the SiO₂ film 50. The resist film 62 is adequate if it has the function of shielding the doping windows other than those of the SiO₂ film for the upper isolating region 24 and the collector leading region 158. A precise mask alignment is unnecessary. It is desirable that the doping windows 63, 64 of the resist film 62 be formed slightly larger than the doping windows 54, 61 in the SiO₂ film 50, as in the resist film 62 shown in Fig. 9 accordingly.

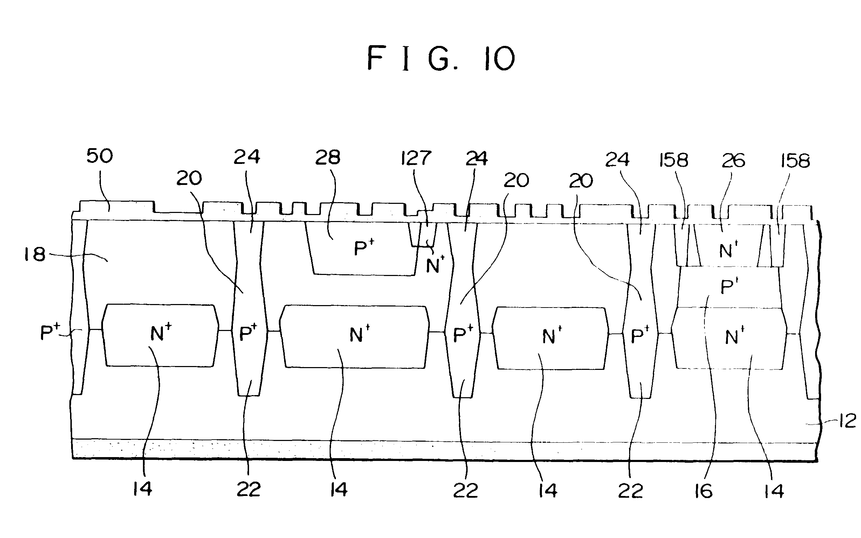

After the resist film 62 is removed, by subjecting the semiconductor substrate 12 to diffusion process under conditions such as, for example, about 1,200°C for one hour, the upper isolating region 24 reaches the lower isolating region 22, and the both regions are linked to form the isolating region 20 as shown in Fig. 10. Also, the collector leading region 158 reaches the P⁺-type buried layer 16.

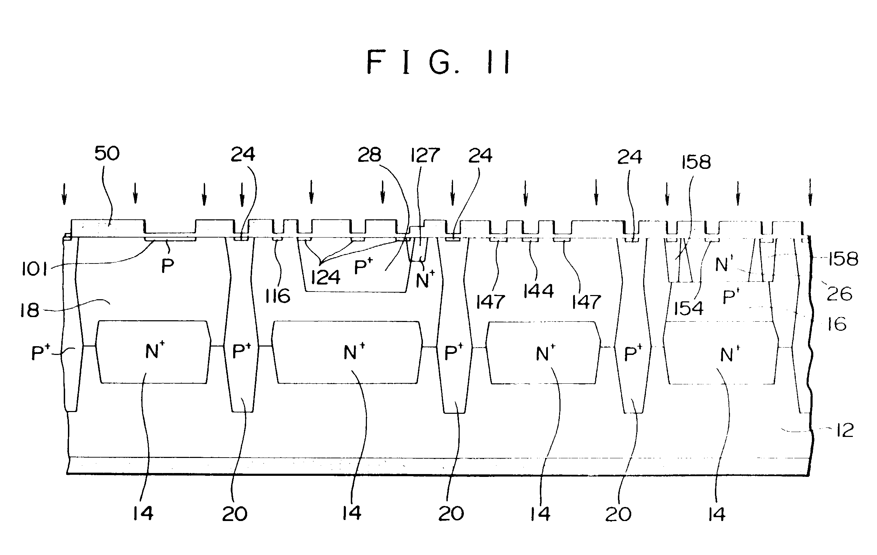

Following the above step, ion implantation with boron is performed using only the SiO₂ film 50 as a mask to make the base region 101 of the vertical NPN transistor, the emitter region 116 of the lateral PNP transistor, the base contact region 124 of the vertical NPN transistor, the emitter region 144 and collector region 147 of the lateral PNP transistor, and the emitter region 154 of the vertical PNP transistor. An impurity is again introduced into the upper isolating region 24 and the collector leading region 158. (See Fig. 11)

In the present invention in which the isolating region 20, the base region 101, and other element regions are formed in this way, retrogradation occurs in the dopant distribution in the upper isolating region 24 directly after ion implantation. The width of the upper isolating region 24 on the epitaxial layer 18 which is at its greatest width through the subsequent diffusion step can be narrowed. A high degree of integration is achieved in the semiconductor integrated circuit. In addition, because retrogradation occurs in the dopant distribution in the upper isolating region 24, the upper isolating region 24 and the lower isolating region 22 can be linked through a comparatively short-time, low-temperature diffusion step, whereby it is also possible to narrow the width of the upper isolating region 24 on the epitaxial layer 18, and, accordingly, to achieve a high degree of integration in the semiconductor integrated circuit.

Also, because the upper isolating region 24 and the lower isolating region 22 are formed in the respective diffusion processes, the diffusion conditions can optionally be designed so as to diffuse the lower isolating region 22 deeply and the upper isolating region 24 shallowly. The lateral diffusion of the upper isolating region 24 can be suppressed, and the width of the exclusive surface area of the upper isolating region 24 which directly affects the degree of integration of the semiconductor integrated circuit can greatly be curtailed. Also, because the lower isolating region 22 which is formed by a longer period of diffusion than that used for the upper isolating region 24 is designed with a large cross section, a small amount of slippage of the mask can be tolerated during the period of formation of the upper isolating region 24. The upper isolating region 24 and the lower isolating region 22 are easily linked, and a complete junction isolation is obtained.

Further, with the first embodiment wherein the positioning of the doping windows 54-61 is determined by a single mask, that is, the SiO₂ film 50, and then the intervals between the upper isolating region 24 and the base region 101 or each of other element regions are primarily determined, the spacing margin for the upper isolating region 24 and each of the other element regions as well as the base region 101 can be drastically reduced. In particular, the lateral distance between the collector leading regions 158 of the vertical PNP transistor can be reduced. This gives the advantages of reducing a collector resistance and a V_{CE} saturation voltage.

Stated additionally, the distance for lateral diffusion of the upper isolating region 24 is usually 0.8 times that for vertical diffusion, so that the respective intervals between the upper isolating region 24 and the regions for the various integrated circuit elements must be rationally designed at 0.8 times or greater the vertical diffusion distance of the upper isolating region 24.

Also, in the present invention in which the number of masking steps is reduced, the problems of contamination of and damage to the semiconductor substrate during the manufacturing stages can be eliminated.

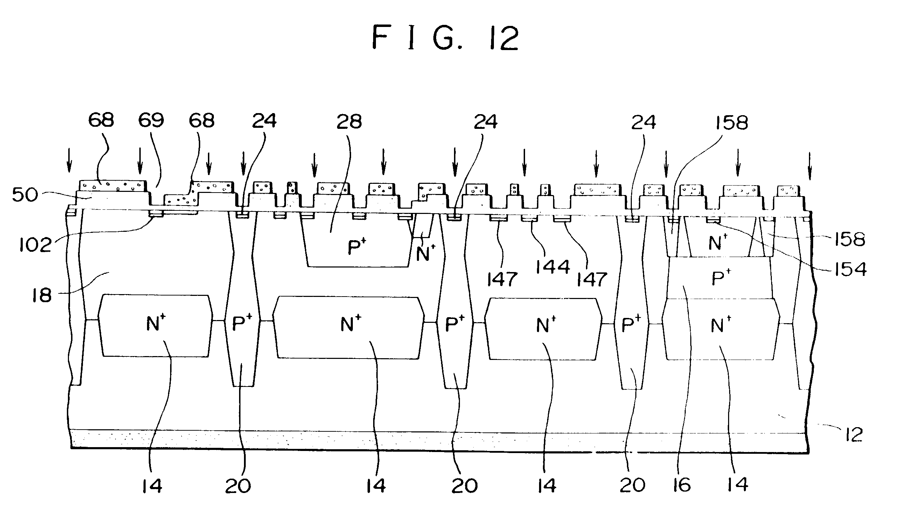

Following the steps related to Fig. 11, a new resist film 68 is formed on the SiO₂ film 50, and at least a doping window 69 for the base contact region 102 within the base region 101 is formed by photolithography. Then, boron (B) ions are implanted through the doping window 69 to form the base contact region 102. (See Fig. 12). The resist film 68 shown in Fig. 12 may have doping windows for the upper isolating region 24, the emitter region 116 of the lateral PNP transistor, the base contact region 124 of the vertical NPN transistor, the emitter region 144 and collector region 147 of the lateral PNP transistor, and the emitter region 154 and collector leading region 158 of the vertical PNP transistor as well as the doping window 69. Each of these doping windows other than the doping window 69 may be appropriately formed depending on an impurity concentration required for each corresponding region.

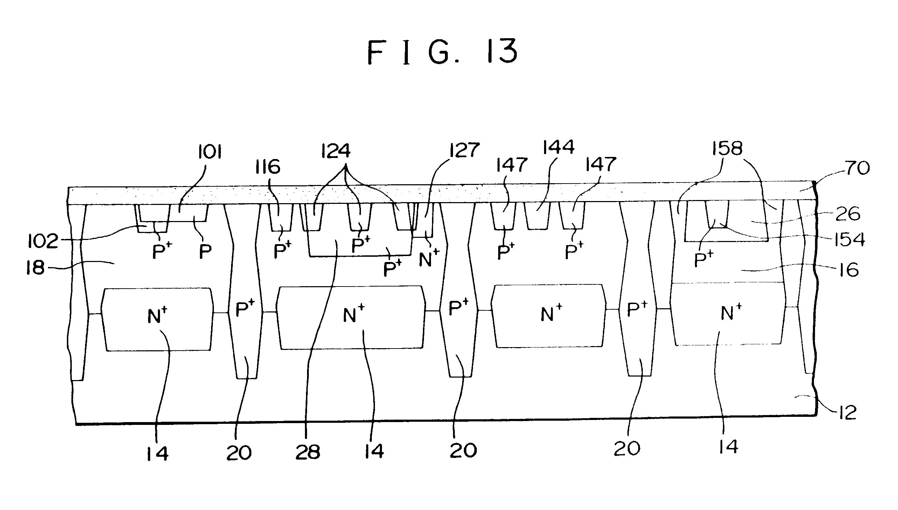

Now referring to Fig. 13, in this step, first, the SiO₂ film 50 on the surface of the epitaxial layer 18 is completely removed and a new SiO₂ film 70 is formed. The SiO₂ film 70 is formed as two layers - an non-doped SiO₂ film and a phosphorous (P) doped SiO₂ film (omitted from the drawing) so as to be capable of gettering Na ions. Alternatively, the SiO₂ film 70 may be formed by first etching the SiO₂ film 50 to substantially a uniform thickness of about 100 nanometres and by laminating a non-doped SiO₂ film and a phosphorous-doped SiO₂ film with a thickness of about several hundred nanometres respectively on the SiO₂ film 50 etched.

As shown in Fig. 14, then openings are formed in the SiO₂ film 70 for the base contact region 102, emitter region 104, and collector contact region 108 of the vertical NPN transistor; the emitter region 116 of the lateral PNP transistor; the base contact region 124, collector regions 130, 131, and emitter contact region 128 of the vertical NPN transistor; the base contact region 142, emitter region 144, and collector region 147 of the lateral PNP transistor; and the base contact region 152, emitter region 154, and collector leading region 158 of the vertical PNP transistor, to provide doping windows and/or contact holes 71-83 for these regions respectively.

A resist film 88 is used to mask the doping windows and/or contact holes 71, 74, 75, 79, 80, 82, and 83 for the base contact region 102, the emitter region 116, the base contact region 124, the emitter region 144, the collector region 147, the emitter region 154, and the collector leading region 158 respectively. Arsenic (As) ions are implanted using the resist film 88 as a mask to simultaneously form the emitter region 104 and collector contact region 108 of the vertical NPN transistor; the collector regions 130, 131 and emitter contact region 128 of the vertical NPN transistor; the base contact region 142 of the lateral PNP transistor; and the base contact region 152 of the vertical PNP transistor.

The most distinctive characteristic of the second embodiment of the present invention is the SiO₂ film 70 of this step. In a conventional semiconductor integrated circuit the film thicknesses of a SiO₂ film in which doping windows and/or contact holes are formed differ according to the location, as shown by the reference number 50 in Fig. 12. For this reason, when the etching of the comparatively thick portions of the SiO₂ film for the collector contact region (which will be formed on the left side of the base contact region 102 in Fig. 12) of the vertical NPN transistor, the base contact region (which will be formed on the right side of the emitter region 154) of the vertical PNP transistor, and the like is completed, side etching proceeds in the comparatively thin portions of the SiO₂ film for the base contact region 102 and the like. Also, there is concern that element regions themselves will be etched, depending on the etchant used.

However, with the second embodiments of the present invention, because the thickness of the entire SiO₂ film 70 is essentially uniform, the etching of the respective portions of the SiO₂ film 70 corresponding to, for example, the collector contact region 108 and the base contact region 152, and the etching of the respective portions of the SiO₂ film 70 for the base contact region 102, the emitter region 104, and other regions are completed simultaneously. The problem of side etching which causes the doping windows and/or the contact holes in the thin portions of the SiO₂ film to become larger than the design value is therefore avoided. In the lateral PNP transistor and the vertical PNP transistor, as a result, each element region of a design size can be formed, and, in particular, a V_{CE} saturation voltage of the vertical PNP transistor 150 can be reduced. There is also the advantage that lowering of the production yield from etching of the emitter region 104 itself is prevented. Furthermore, because it is possible to use the SiO₂ film 70 as a mother mask in the same way as the SiO₂ film 50 in the steps illustrated before, slippage of the masking pattern of the photoresist film 88 can consequently be tolerated, giving the advantage that it is unnecessary to provide a large margin of spacing between the upper isolating region 24 and the other element regions.

Following to the previous step, the semiconductor substrate 12 is heat-treated after the removal of the photoresist film 88, to diffuse downward the N⁺-type regions (for example, emitter region 104) formed by the ion-implantation of arsenic (As). After that, the slight SiO₂ film which was newly formed at the doping windows is removed by light etching, and an electrode 90 is formed by means of aluminum vapor deposition as shown in Fig. 15. Stated additionally, the reference numbers of a part of the regions in Fig. 15 are those for the configuration of the transistors.

## Claims

1. A method of manufacturing a semiconductor integrated circuit comprising the steps of:
(i) forming a first insulating layer on the surface of a first conductive-type semiconductor layer;
(ii) forming doping windows in the first insulating layer for a second conductive-type upper-isolating region and mainly second conductive-type integrated circuit element regions simultaneously;
(iii) masking the doping windows in the first insulating layer for the integrated circuit element regions and doping the semiconductor layer with a second conductive-type dopant to selectively form the upper isolating region in the semiconductor layer;
(iv) doping the semiconductor layer with a second conductive-type dopant through doping windows or a part of the doping widows for a specified area in the first insulating layer to form the second conductive-type integrated circuit element regions in the semiconductor layer;
(v) forming a second insulating layer after removing the first insulating layer;
(vi) forming, in the second insulating layer, doping windows for mainly first conductive-type integrated circuit element regions; and
(vii) doping the semiconductor layer with a first conductive-type dopant through the doping windows in the second insulating layer to selectively form the first conductive-type integrated circuit element regions.

2. The method for manufacturing a semiconductor integrated circuit according to Claim 1, wherein the second conductive-type element region is a base region of a vertical transistor.

3. The method for manufacturing a semiconductor integrated circuit according to Claim 2, wherein the second conductive-type integrated circuit element region is a base contact region formed within the base region of a vertical transistor.

4. The method for manufacturing a semiconductor integrated circuit according to Claim 1, wherein the second conductive-type element regions are an emitter region and collector region of a lateral transistor.

5. The method for manufacturing a semiconductor integrated circuit according to Claim 4, wherein the collector region is formed within a second conductive-type well region.

6. The method for manufacturing a semiconductor integrated circuit according to Claim 5, wherein the first conductive-type element region is formed within the second conductive-type well region.

7. The method for manufacturing a semiconductor integrated circuit according to Claim 1, wherein the second conductive-type element regions are an emitter region and collector leading region of a vertical transistor.

8. The method for manufacturing a semiconductor integrated circuit according to Claim 7, wherein the emitter region is formed within a first conductive-type well region.

9. A method of manufacturing a semiconductor integrated circuit comprising the steps of:
(1) forming a first insulating layer (50) on the surface of a first conductive-type semiconductor layer (18);
(2) forming doping windows (60),(61) in the first insulating layer (50) for second conductive-type integrated circuit element regions simultaneously, which are a collector leading region (158) and an emitter region (154) of a vertical PNP transistor (150);
(3) masking with a resist film(62) the doping window (60) in the first insulating layer for the emitter region (154) of the vertical PNP transistor(150) and doping the semiconductor layer with a second conductive-type dopant through the doping window (61) to form the collector leading region (158) of the vertical PNP transistor (150) in the semiconductor layer;
(3') doping the semiconductor layer with a second conductive-type dopant through doping window (60) for the emitter region (154) of the vertical PNP transistor (150) after removing the mask (62);
(4) forming a second insulating layer (70) after removing the first insulating layer(50);
(5) forming,in the second insulating layer (70), a doping window (81) for a base contact region (152) and contact holes (83),(82) for the collector leading region (158) and the emitter region (154) of the vertical PNP transistor(150);
(6) masking the contact holes (83),(82) in the second insulating layer(70) for the collector leading region (158) and the emitter region (154) of the vertical PNP transistor (150); and
(7) doping the semiconductor layer with a first conductive-type dopant through the doping window (81) in the second insulating layer (70) for the first conductive-type base contact region (152) to selectively form the first conductive-type base contact region (152) and the contact region in the semiconductor layer for the collector leading region (158) and the emitter region (154) of the vertical PNP transistor.

## Patentansprüche

1. Verfahren zum Herstellen einer integrierten Halbleiterschaltung, mit den folgenden Schritten:
(i) Herstellen einer ersten Isolierschicht auf der Oberfläche einer Halbleiterschicht von erstem Leitungstyp;
(ii) gleichzeitiges Ausbilden von Dotierfenstern in der ersten Isolierschicht für einen oberen Isolierbereich von zweitem Leitungstyp und Elementbereichen der integrierten Schaltung vom hauptsächlich zweiten Leitungstyp;
(iii) Maskieren der Dotierfenster in der ersten Isolierschicht für die Elementbereiche der integrierten Schaltung, und Dotieren der Halbleiterschicht mit einem Dotierstoff vom zweiten Leitungstyp, um in der Halbleiterschicht selektiv den oberen Isolierbereich auszubilden;
(iv) Dotieren der Halbleiterschicht mit einem Dotierstoff vom zweiten Leitungstyp durch Dotierfenster oder einen Teil der Dotierfenster für einen vorgegebenen Bereich in der ersten Isolierschicht, um die Elementbereiche der integrierten Schaltung vom zweiten Leitungstyp in der Halbleiterschicht auszubilden;
(v) Herstellen einer zweiten Isolierschicht nach dem Entfernen der ersten Isolierschicht;
(vi) Ausbilden von Dotierfenstern in der zweiten Isolierschicht für Elementbereiche der integrierten Schaltung vom hauptsächlich ersten Leitungstyp; und
(vii) Dotieren der Halbleiterschicht mit einem Dotierstoff vom ersten Leitungstyp durch die Dotierfenster in der zweiten Isolierschicht hindurch, um selektiv die Elementbereiche der integrierten Schaltung vom ersten Leitungstyp auszubilden.

2. Verfahren zum Herstellen einer integrierten Halbleiterschaltung nach Anspruch 1, bei dem der Elementbereich vom zweiten Leitungstyp der Basisbereich eines Vertikaltransistors ist.

3. Verfahren zum Herstellen einer integrierten Halbleiterschaltung nach Anspruch 2, bei dem der Elementbereich der integrierten Schaltung vom zweiten Leitungstyp ein Basiskontaktbereich ist, der innerhalb des Basisbereichs eines Vertikaltransistors ausgebildet ist.

4. Verfahren zum Herstellen einer integrierten Halbleiterschaltung nach Anspruch 1, bei dem die Elementbereiche vom zweiten Leitungstyp der Emitterbereich und der Kollektorbereich eines Lateraltransistors sind.

5. Verfahren zum Herstellen einer integrierten Halbleiterschaltung nach Anspruch 4, bei dem der Kollektorbereich innerhalb eines Wannenbereichs vom zweiten Leitungstyp ausgebildet wird.

6. Verfahren zum Herstellen einer integrierten Halbleiterschaltung nach Anspruch 5, bei dem der Elementbereich vom ersten Leitungstyp innerhalb des Wannenbereichs vom zweiten Leitungstyp ausgebildet wird.

7. Verfahren zum Herstellen einer integrierten Halbleiterschaltung nach Anspruch 1, bei dem die Elementbereiche vom zweiten Leitungstyp der Emitterbereich und der Kollektorzuleitungsbereich eines Vertikaltransistors sind.

8. Verfahren zum Herstellen einer integrierten Halbleiterschaltung nach Anspruch 7, bei dem der Emitterbereich innerhalb des Wannenbereichs vom ersten Leitungstyp ausgebildet wird.

9. Verfahren zum Herstellen einer integrierten Halbleiterschaltung, mit den folgenden Schritten:
(1) Herstellen einer ersten Isolierschicht (50) auf der Oberfläche einer Halbleiterschicht (18) von erstem Leitungstyp;
(2) gleichzeitiges Ausbilden von Dotierfenstern (60, 61) in der ersten Isolierschicht (50) für Elementbereiche einer integrierten Schaltung von zweitem Leitungstyp, die einen Kollektorzuleitungsbereich (158) und einen Emitterbereich (154) eines pnp-Vertikal-Transistors (150) sind;
(3) Maskieren des Dotierfensters (60) in der ersten Isolierschicht für den Emitterbereich (154) des pnp-Vertikal-Transistors (150) mit einem Resistfilm (62), und Dotieren der Halbleiterschicht mit einem Dotierstoff vom zweiten Leitungstyp durch das Dotierfenster (61) hindurch, um den Kollektorzuleitungsbereich (158) des pnp-Vertikal-Transistors (150) in der Halbleiterschicht auszubilden;
(3') Dotieren der Halbleiterschicht mit einem Dotierstoff vom zweiten Leitungstyp durch das Dotierfenster (60) für den Emitterbereich (154) des pnp-Vertikaltransistors (150) hindurch, nachdem die Maske (62) entfernt wurde;
(4) Herstellen einer zweiten Isolierschicht (70) nach dem Entfernen der ersten Isolierschicht (50);
(5) Ausbilden, in der zweiten Isolierschicht (70) , eines Dotierfensters (81) für einen Basiskontaktbereich (152) sowie von Kontaktlöchern (83, 82) für den Kollektorzuleitungsbereich (158) und den Emitterbereich (154) des pnp-Vertikal-Transistors (150);
(6) Maskieren der Kontaktlöcher (83, 82) in der zweiten Isolierschicht (70) für den Kollektorzuleitungsbereich (158) und den Emitterbereich (154) des pnp-Vertikaltransistors (150); und
(7) Dotieren der Halbleiterschicht mit einem Dotierstoff vom ersten Leitungstyp durch das Dotierfenster (81) in der zweiten Isolierschicht (70) für den Basiskontaktbereich (152) vom ersten Leitungstyp, um den Basiskontaktbereich (152) vom ersten Leitungstyp und den Kontaktbereich in der Halbleiterschicht für den Kollektorzuführungsbereich (158) und den Emitterbereich (154) des pnp-Vertikal-Transistors selektiv auszubilden.

## Revendications

1. Procédé de fabrication d'un circuit intégré à semiconducteurs comprenant les étapes consistant à:
(i) former une première couche isolante à la surface d'une première couche de semi-conducteur de type conductrice;
(ii) former des fenêtres de dopage dans la première couche isolante pour une seconde région isolante supérieure de type conductrice et principalement des secondes régions d'élément de circuit intégré de type conductrice, de manière simultanée;
(iii) masquer les fenêtres de dopage dans la première couche isolante pour les régions d'élément de circuit intégré et doper la couche de semi-conducteur avec un second dopant de type conducteur pour former de manière sélective la région isolante supérieure dans la couche de semi-conducteur;
(iv) doper la couche de semi-conducteur avec un second dopant de type conducteur à travers des fenêtres de dopage ou une partie des fenêtres de dopage pour une zone spécifiée dans la première couche isolante afin de former les secondes régions d'élément de circuit intégré de type conductrice dans la couche de semi-conducteur;
(v) former une seconde couche isolante après enlèvement de la première couche isolante;
(vi) former, dans la seconde couche isolante, des fenêtres de dopage pour principalement des premières régions d'élément de circuit intégré de type conductrice; et
(vii) doper la couche de semi-conducteur avec un premier dopant de type conducteur à travers les fenêtres de dopage dans la seconde couche isolante pour former de manière sélective les premières régions d'élément de circuit intégré de type conductrice.

2. Procédé pour fabriquer un circuit intégré à semi-conducteurs selon la revendication 1, dans lequel la seconde région d'élément de type conductrice est une région de base d'un transistor vertical.

3. Procédé pour fabriquer un circuit intégré à semi-conducteurs selon la revendication 2, dans lequel la seconde région d'élément de circuit intégré de type conductrice est une région de contact de base formée à l'intérieur d'une région de base d'un transistor vertical.

4. Procédé pour fabriquer un circuit intégré à semi-conducteurs selon la revendication 1, dans lequel les secondes régions d'élément de type conductrice sont une région d'émetteur et une région de collecteur d'un transistor latéral.

5. Procédé pour fabriquer un circuit intégré à semi-conducteurs selon la revendication 4, dans lequel la région de collecteur est formée à l'intérieur d'une seconde région de puits de type conductrice.

6. Procédé pour fabriquer un circuit intégré à semi-conducteurs selon la revendication 5, dans lequel la première région d'élément de type conductrice est formée à l'intérieur de la seconde région de puits de type conductrice.

7. Procédé pour fabriquer un circuit intégré à semi-conducteurs selon la revendication 1, dans lequel les secondes régions d'élément de type conductrice sont une région d'émetteur et une région avant de collecteur d'un transistor vertical.

8. Procédé pour fabriquer un circuit intégré à semi-conducteurs selon la revendication 7, dans lequel la région d'émetteur est formée à l'intérieur d'une première région de puits de type conductrice.

9. Procédé de fabrication d'un circuit intégré semi-conducteurs comprenant les étapes consistant à:
(1) former une première couche isolante (50) à la surface d'une première couche de semi-conducteur de type conductrice (18);
(2) former des fenêtres de dopage (60), (61), dans la première couche isolante (50) pour des secondes régions d'élément de circuit intégré de type conductrice, de manière simultanée, qui sont constituées par une région avant de collecteur (158) et une région d'émetteur (154) d'un transistor PNP vertical (150);
(3) masquer avec un film de résist (62) la fenêtre de dopage (60) dans la première couche isolante pour la région d'émetteur (154) du transistor PNP vertical (150) et doper la couche de semi-conducteur avec un second dopant de type conducteur à travers la fenêtre de dopage (61) pour former la région avant de collecteur (158) du transistor PNP vertical (150) dans la couche de semi-conducteur;
(3') doper la couche de semi-conducteur avec un second dopant de type conducteur à travers une fenêtre de dopage (60) pour la région d'émetteur (154) du transistor PNP vertical (150), après enlèvement du masque (62);
(4) former une seconde couche isolante (70) après enlèvement de la première couche isolante (50);
(5) former, dans la seconde couche isolante (70), une fenêtre de dopage (81) pour une région de contact de base (152) et des trous de contact (83), (82), pour la région avant de collecteur (158) et la région d'émetteur (154) du transistor PNP vertical (150);
(6) masquer les trous de contact (83), (82), dans la seconde couche isolante (70) pour la région avant de collecteur (158) et la région d'émetteur (154) du transistor PNP vertical (150); et
(7) doper la couche de semi-conducteur avec un premier dopant de type conducteur à travers la fenêtre de dopage (81) dans la seconde couche isolante (70) pour la première région de contact de base de type conductrice (152) afin de former de manière sélective la première région de contact de base de type conductrice (152) et la région de contact dans la couche de semi-conducteur pour la région avant de collecteur (158) et la région d'émetteur (154) du transistor PNP vertical.
